# EUROPEAN PATENT APPLICATION

(11) **EP 0 827 187 A2**
(43) Date of publication of application: **04.03.1998**
(21) Application number: 97306500.6
(22) Date of filing: 26.08.1997
(51) Int. Cl.: H01L 21/00, H01L 21/68

(54) **Method and apparatus for cooling a workpiece using an electrostatic chuck**

(30) Priority: 26.08.1996 US 703245
(71) Applicant: Applied Materials, Inc., Santa Clara, California 95054 (US)
(72) Inventor: Parkhe, Vijay D., Sunnyvale, California 94086 (US)
(74) Representative: Bayliss, Geoffrey Cyril

(57) **Abstract**

The disclosure relates to an apparatus and method for cooling a workpiece comprising a cooldown chamber (102) providing a vacuum sealed enclosure containing a thermally conductive pedestal (206) having a support surface upon which is affixed an electrostatic chuck (200) for supporting and electrostatically retaining the workpiece. The electrostatic chuck retains a wafer in close contact with the pedestal such that heat conduction from the wafer to the pedestal is substantially improved. Such close contact between the wafer and the chuck facilitates the use of a backside cooling technique from a coolant gas source (210) to further promote the conduction of heat to the chuck.

## Description

The invention relates to a substrate support chuck for supporting a semiconductor wafer within a semiconductor processing system. More particularly, the invention relates to a cooldown chamber within a semiconductor processing system, where the cooldown chamber retains a workpiece therein using an electrostatic chuck.

Modern semiconductor processing systems utilize a sequence of stages to process a given semiconductor wafer. Typically, each stage of the process is accomplished within an individual process chamber and a robotic transport mechanism transports the wafer from stage to stage within the system. Each stage of the process generally has particular environmental requirements that differ from the requirements of other stages within the system. As such, after completion of processing within one stage that, for example, may operate at a very high temperature, e.g., in excess of 400°C, the wafer must be cooled before it is transported to the next stage. In some instances, placing a "hot" wafer into certain types of atmospheres may cause undesirable reactions that would make the wafer unusable. Furthermore, after processing in the last stage of the semiconductor processing system, the wafer must be cooled prior to being placed within a plastic transport cassette.

To facilitate cooling the wafer in a benign environment, an intermediary stage is used, i.e., a cooldown chamber provides a cooldown stage. A cooldown chamber contains a liquid cooled aluminum pedestal having a wafer support surface upon which a wafer can be placed by the robotic transport mechanism. The pedestal is located within a vacuum chamber such that a cooldown environment can be created to rapidly cool a wafer via conduction to the pedestal and convection to the chamber atmosphere. Typically, once the transport mechanism places a wafer upon the pedestal, the chamber is sealed, and the pressure within the chamber is raised by introducing argon to produce a chamber pressure of two to four Torr. The "fill time" is approximately 20 seconds. As the chamber is filled, turbulence can detrimentally move the wafer across the surface of the pedestal. Once an argon atmosphere is present, the wafer is typically cooled in 30 to 40 seconds from 450°C to 150°C. Once the wafer is cooled, the chamber can be pumped down to a vacuum and the transport mechanism re-enters the chamber to remove the cooled wafer. To expedite wafer retrieval, the cooldown chamber is not formally pumped to a vacuum, but rather the chamber is merely opened to the portion of the system that contains the transport mechanism. This portion of the system is known as a buffer chamber. A vacuum is maintained in the buffer chamber such that the cooldown chamber atmosphere can be "dumped" into the buffer chamber and then pumped from the buffer chamber using a cryogenic pump (cryo pump).

One disadvantage of using a cooldown chamber atmosphere in this manner is that dumping the atmosphere requires that the cryo pump must be regenerated often. Such cryo pump regeneration can require up to 120 to 360 minutes to complete. Such movement can abrade material from the underside of the wafer, producing potential contaminant particles.

To avoid the need for repeated cryo pump regeneration due to dumping the cooldown chamber atmosphere it would be advantageous to cool the wafer in a vacuum to avoid the use of the cooldown chamber atmosphere.

Therefore, there is a need in the art for a chuck within a cooldown chamber of a semiconductor wafer processing system that facilitates improved cooling of a semiconductor wafer without the need for a cooldown chamber atmosphere.

The disadvantages heretofore associated with the prior art are overcome by an inventive apparatus for cooling a workpiece (e.g., a semiconductor wafer) containing an electrostatic chuck for supporting and retaining the workpiece proximate a thermally conductive pedestal. The electrostatic chuck retains a workpiece in close contact with the pedestal such that heat conduction from the workpiece to the pedestal is substantially improved over the prior art. Such close contact between the wafer and the chuck facilitates the use of a backside cooling technique to further promote the conduction of heat from the workpiece to the chuck.

The electrostatic chuck of the present invention is affixed to a thermally conductive mounting plate. The mounting plate is releasably attached to a thermally conductive pedestal base that contains coolant flow conduits that maintain the pedestal at a low temperature. The pedestal base has a top surface upon which the electrostatic chuck is releasably affixed, for example, by a plurality of bolts or screws.

Optionally, a heating element is located between the chuck and the pedestal. The heating element is activated to periodically bake out the cooldown chamber to remove water vapor. Alternatively, external heating elements, such as lamps, are mounted external to the chamber to perform the bake out function.

In the preferred embodiment of the invention, the electrostatic chuck comprises a first polymeric dielectric layer which is affixed to a mounting plate. Upon the first polymeric dielectric layer, a pair of coplanar electrodes are deposited or affixed and, upon the electrode pair, a second polymeric dielectric layer is deposited or affixed. This second polymeric dielectric layer forms a support surface upon which a semiconductor wafer will be positioned during the cooling phase of semiconductor wafer processing. To facilitate support of wafers having temperatures of 100°C or more, the polymeric dielectric material is a high temperature polyimide.

The electrodes of the chuck are connected, via wires and vacuum sealed through-connectors, through the chamber walls to the positive and negative terminals of a high voltage DC power supply (e.g., supplying 200 to 2,000 volts). To facilitate releasable attachment of the chuck to the pedestal base, the electrodes connect to terminals in the pedestal base via a spring loaded connector assembly. When voltage is applied to the pair of electrodes, opposite polarity charges are accumulated on the underside of the wafer. Such charges are attracted to the electrode potential but do not migrate through the polyimide layer. As such, the wafer, as a whole, is attracted to the electrodes within the electrostatic chuck, and consequently, the wafer is retained thereupon by coulomb force.

Once "chucked", the wafer is closely held to the top surface of the second polymeric dielectric layer. Such close contact provides a thermally conductive path from the wafer to the cooled pedestal. As such, the heat within the wafer quickly conducts through the polyimide layer, the electrodes, the first polyimide layer and the mounting plate into the cooled pedestal. The heat from the wafer is rapidly carried by the coolant flowing through the pedestal to a heat exchanger.

To further enhance heat conduction, a coolant gas such as argon is provided to the interstitial spaces between the wafer and the support surface of the chuck. The gas is supplied from a coolant gas source to the wafer backside via a centrally located portal through the pedestal and the chuck. Distribution channels may be formed in the support surface to improve gas distribution along the wafer backside.

Using an electrostatic chuck having a polymeric dielectric support surface, backside gas cooling and a liquid cooled pedestal, a wafer can be cooled from 450°C to 100°C in approximately 10-15 seconds. This is a three- to four-fold improvement in cooling time as compared to the prior art. Furthermore, the present invention does not require a cooling atmosphere within the cooldown chamber to achieve superior cooling times. As such, the cooldown chamber does not require filling and dumping of the cooldown chamber atmosphere that may cause wafer abrasion and repeated cryo pump regeneration.

The teachings of the present invention can be readily understood by considering the following detailed description in conjunction with the accompanying drawings, in which:
FIG. 1 depicts a simplified, top plan view of a multichamber semiconductor wafer processing system containing a cooldown chamber that embodies the present invention;
FIG. 2 depicts a vertical cross-sectional view of the cooldown chamber taken along line 2-2 of FIG. 1 and FIG. 3;
FIG. 3 is a top plan view of the electrostatic chuck used in the present invention;
FIG. 4 depicts a cross-sectional view of a spring-loaded electrical connector for releasably connecting a chuck electrode to a power supply; and
FIG. 5A-5E depict process steps for fabricating the electrostatic chuck.

To facilitate understanding, identical reference numerals have been used, where possible, to designate identical elements that are common to the figures.

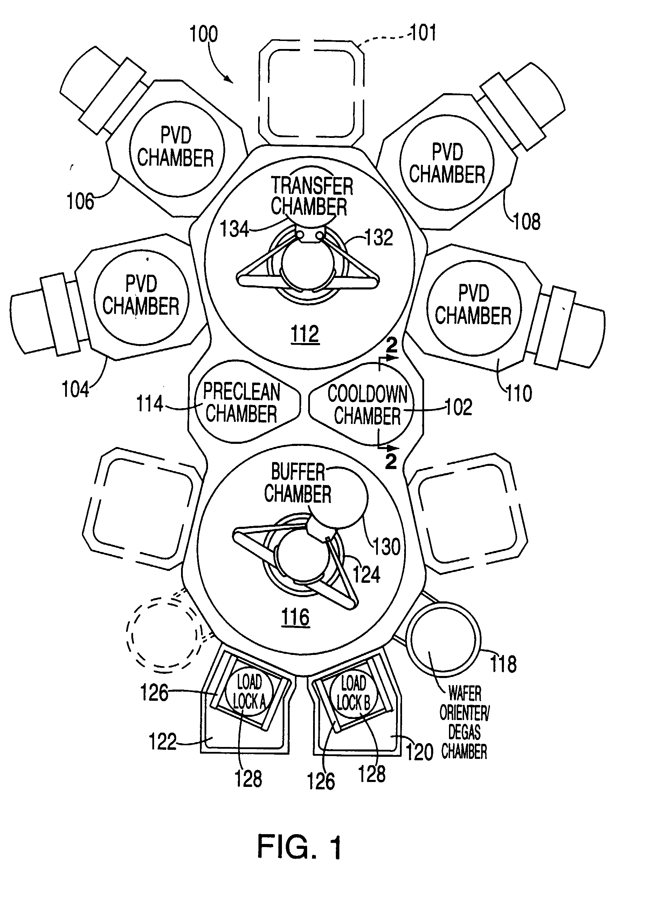

FIG. 1 depicts a simplified, top plan view of a multichamber semiconductor wafer processing system 100 containing at least one cooldown chamber 102 that embodies the present invention. One commercially available example of a multichamber system 100 is the Endura system manufactured by Applied Materials, Inc. of Santa Clara, California.

The system 100 contains, for example, four process chambers 104, 106, 108, 110, a transfer chamber 112, a preclean chamber 114, a buffer chamber 116, a wafer orienter/degas chamber 118 and a pair of load-lock chambers 120 and 122. The system may also contain a second cooldown chamber 101 (shown in phantom). Each chamber represents a different stage or phase of semiconductor wafer processing. The buffer chamber 116 is centrally located with respect to the load lock chambers 120 and 122, the wafer orienter/degas chamber 118, the preclean chamber 114 and the cooldown chamber 102. To effectuate wafer transfer amongst these chambers, the buffer chamber 116 contains a first robotic transfer mechanism 124. The wafers 128 are typically carried from storage to the system in a plastic transport cassette 126 that is placed within one of the load-lock chambers 120 or 122. The robotic transport mechanism 124 transports the wafers 128, one at a time, from the cassette 126 to any of the three chambers 118, 102, or 114. Typically, a given wafer is first placed in the wafer orienter/degas chamber 118, then moved to the preclean chamber 114. The cooldown chamber 102 is generally not used until after the wafer is processed within the process chambers 104, 106, 108, 110. Individual wafers are carried upon a wafer transport blade 130 that is located at the distal end of the first robotic mechanism 124.

The transfer chamber 112 is surrounded by and has access to the four process chambers 104, 106, 108 and 110 as well as the preclean chamber 114 and the cooldown chamber 102. To effectuate transport of a wafer amongst the chambers, the transfer chamber 112 contains a second robotic transport mechanism 132. The mechanism 132 has a wafer transport blade 134 attached to its distal end for carrying the individual wafers.

In operation, the wafer transport blade 134 of the second transport mechanism 132 retrieves a wafer from the preclean chamber 114 and carries that wafer to the first stage of processing, for example, a physical vapor deposition (PVD) stage within chamber 104. This stage may operate at a high temperature, for example, in excess of 175°C. Once the wafer is processed and the PVD stage deposits material upon the wafer, the wafer can then be moved to a second stage of processing. However, if that second stage of processing is a low temperature process stage, the wafer must be cooled before it is positioned within a chamber that performs the second stage of processing. Consequently, once the wafer is retrieved from the high temperature chamber 104, it is placed within the cooldown chamber 102 or 101.

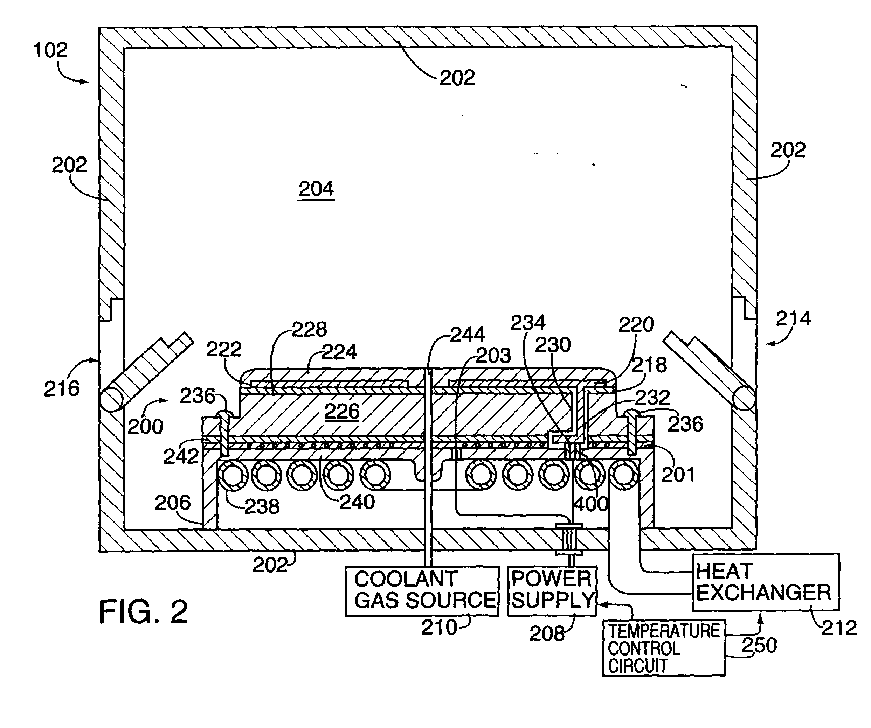

The cooldown chamber 102 (or 101), in accordance with one aspect of the invention, contains an electrostatic chuck for electrostatically retaining the wafer. The electrostatic chuck retains the wafer in close proximity to a liquid cooled pedestal which rapidly removes the heat from the wafer to a heat exchanger. The electrostatic chuck used in the cooldown chamber is described in detail with reference to FIG. 2 below.

Once the wafer is cooled within the cooldown chamber, the second transport mechanism 132 moves the wafer to the low temperature chamber 106 for further processing. Although the low temperature chamber 106 may operate at a "low" temperature compared to the high temperature processing stage, the temperature within the chamber may be high enough that, after processing, the wafer cannot be moved directly from the chamber 106 and returned to the buffer chamber 116. As such, the wafer must again be cooled after processing within the low temperature chamber 106. Of course, the wafer may also require further processing in other chambers that are accessible via the transfer chamber 132. Once processing is complete within the process chambers, the transport mechanism 132 moves the wafer from the process chamber and transports the wafer to the electrostatic chuck within the cooldown chamber 102. The cooling process is repeated and the wafer is then removed from the cooldown chamber using the first transport mechanism 124 within the buffer chamber 116. Lastly, the wafer is placed in the transport cassette 126 within the load-lock chamber 122.

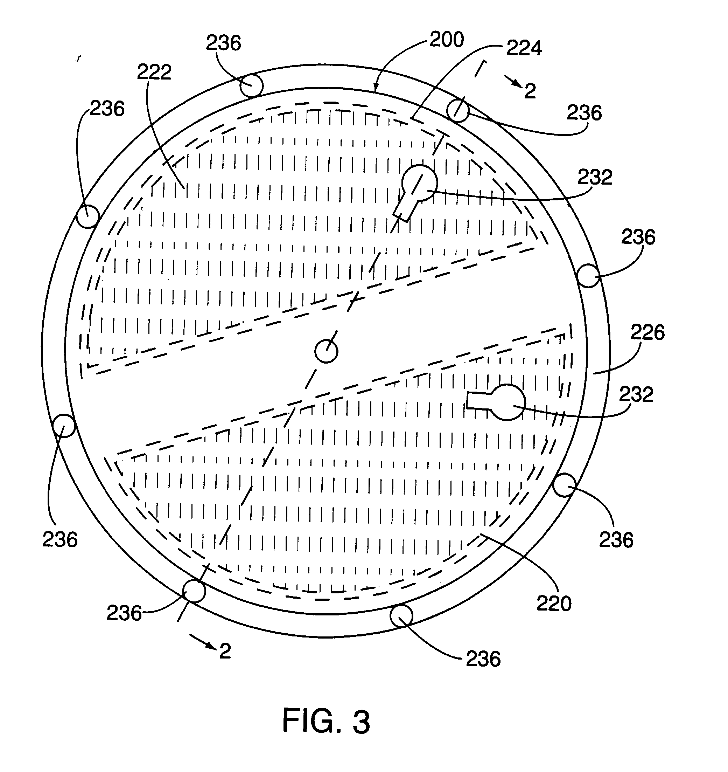

FIG. 2 depicts a vertical cross-sectional view of the cooldown chamber 102 and the bipolar electrostatic chuck 150 taken along line 2-2 in FIGS. 1 and 3. FIG. 3 is a top plan view of the electrostatic chuck of FIG. 2. To best understand the invention, the reader should simultaneously refer to FIGS. 2 and 3.

The cooldown chamber 102 is an assemblage of components including a vacuum-sealed enclosure comprising a plurality of sides 202 defining an internal volume 204, a pedestal 206 (also known as a cooling block), a heater element 201, an electrostatic chuck 200, a power supply 208, a coolant gas source 210, and a heat exchanger 212. The first robotic transport mechanism (124 of FIG. 1) is provided access to the volume 204 via a pivotal door 214 located in the sidewall of the chamber. Similarly, the second robotic transport mechanism (132 in FIG. 1) is provided access to the volume 204 via a pivotal door 216 located in a sidewall of the chamber. Generally, doors 214 and 216 are located in opposing sidewalls of the chamber.

The preferred embodiment of the electrostatic chuck 200 comprises a first polymeric dielectric layer 218, a pair of electrodes 220 and 222, and a second polymeric dielectric layer 224. To provide structural rigidity to the chuck, the first dielectric layer 218 is affixed to a thermally conductive mounting plate 226.

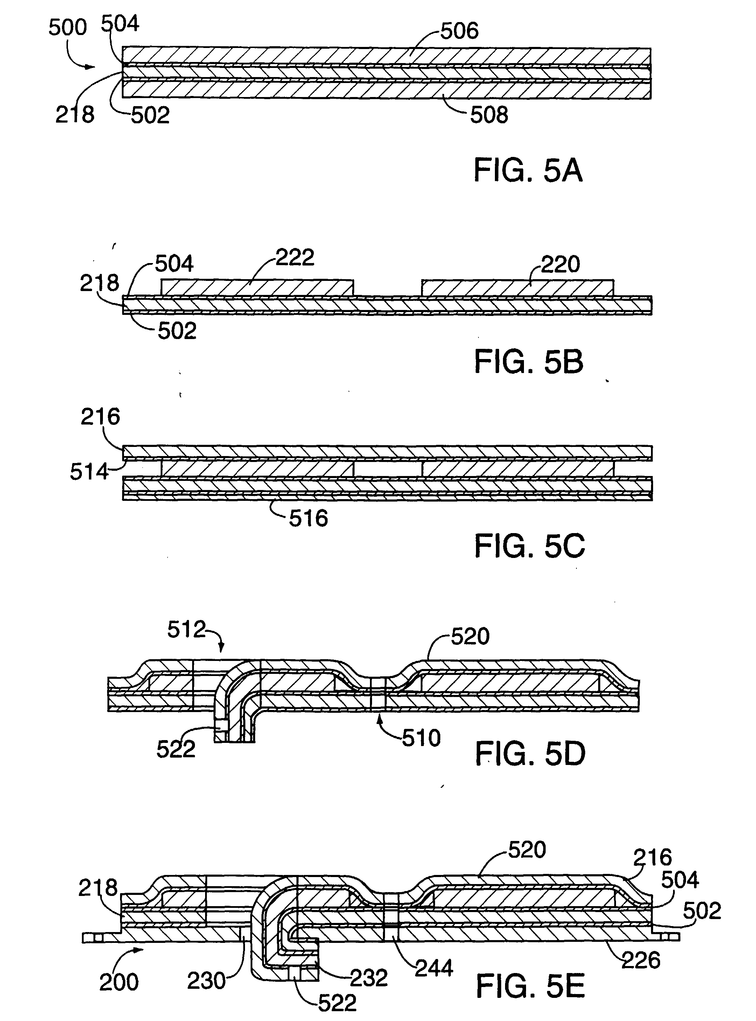

More specifically, the electrostatic chuck 200 is affixed atop the mounting plate 226. The chuck comprises a first self-adhering dielectric layer 218 having a thickness of 1 to 2 mils adhered to the plate 226; a conductive layer (electrodes 220 and 222) which overlays the first dielectric layer 218 (the conductive layer containing electrodes 220 and 222 can be patterned into various geometries, FIG. 3 illustrates a bipolar electrode pattern); and a second self-adhering dielectric layer 224 having a thickness of 1 to 2 mils. Plate 226 includes an aperture 230 through which a conductive extension 232 extends to furnish an electrical contact surface 234 through which power is connected to electrode 220. The other electrode 224 is similarly provided an aperture and conductive extension (not shown in FIG. 2). These extension are formed (as discussed with respect to FIG. 5 below) as lolly pop shaped "tabs". The outline of the tabs are depicted in FIG. 3.

Although the depicted chuck 200 and pedestal 206 is for a circular silicon wafer, such a pedestal may be rectangular or have any shape advantageous to the substrate used for production of the semiconductor device.

At least one, and preferably both, of the dielectric layers of the electrostatic chuck 200 are constructed from a polymeric dielectric material such as polyimide, which provides flexibility and low cost in comparison with ceramic and oxide dielectric materials in general. However, as shall be discussed below, other forms of electrostatic chucks can be substituted for the polyimide-based chuck without exceeding the scope of the invention.

More specifically, the lower first polyimide film 208 is adhered to the mounting plate 226. Previously such attachment would have been achieved using methyl methacrylate (acrylic) based adhesive layers; however, such adhesive layers cannot withstand high temperatures. To avoid the need to use such acrylic adhesives, the first polyimide film 218 is formed using a polyimide film which is sufficiently thermoplastic that it can flow and bond to the pedestal under the application of heat and pressure. A preferred material for use as lower polyimide film 218 is a hydrophobic material such as Kapton® KJ, available from DuPont. Kapton® KJ , for example, is a thermoplastic polyimide adhesive film with a glass transition temperature (Tg) around 220°C. Kapton® KJ is available in thicknesses as low as 0.5 mil (12 microns), has a relatively low Z-axis coefficient of thermal expansion (CTE, ca. 65 ppm/°C), and most physical properties are comparable to other polyimide films. At elevated temperatures, Kapton® KJ has two softening points, with a second transition temperature above the Tg of 220°C, in the range of 280°C to 350°C, which may be considered as the crystalline transition (Tm). This second transition temperature range functions as a process window for effective bonding of the Kapton® KJ to a metallic substrate such as mounting plate 226 (typically constructed of stainless steel or aluminum). Kapton® KJ has been shown to bond to a variety of metallic and non-metallic substrates. Bonding is accomplished above 280°C (preferably at 350°C) and 200 or more psi (preferably 300 psi) using a vacuum assisted hydraulic press or autoclave for bonding the Kapton® KJ to other materials including copper, steel, ceramics, and films.

The electrodes 220 and 222 of electrostatic chuck 200 can be constructed from a number of materials such as copper-surfaced cladply polyimide film, aluminum cladply polyimide film, and aluminum-filled polyimide film available from Ablestik Laboratories, Rancho Dominguez, California. One preferred conductive layer is available from DuPont as Paralux® AP, an adhesiveless composite of polyimide film bonded to copper foil. The copper is typically rolled annealed copper, but electrodeposited copper is also available.

Other materials available for use in construction of electrostatic chuck 200 include polyimide cladply materials available from DuPont under the trade names Kapton® HKJ and EKJ or UPILEX® from UBE Industries, Ltd. Kapton® HKJ and EKJ are heat-sealable/self-adhering composite films, generally consisting of at least one layer of Kapton® KJ on top of a core polyimide film layer that is non-thermoplastic and has a higher glass transition temperature (e.g., Tg of 350° C). The non-thermoplastic core layer may be selected from materials such as commonly used H-polymer (PMDA/ODA) or from E-polymer (a low thermal expansion polymer of undefined composition available from DuPont). The layer thickness of cladply materials can be varied to meet specific needs. In addition, the cladply material can have a thermoplastic adhering layer on one side or on both sides of the non-thermoplastic core layer, depending on the application. Typically the thermoplastic adhesive layer thickness ranges from about 0.1 - 0.5 mils (2.4 - 12 microns), while the core layer thickness ranges from about 0.5 - 2.0 mils (12 - 48 microns). Thermal coefficient of expansion for the cladply material having an H-polymer core is about 45 ppm/°C, dielectric strength is about 5600 V/mil, dielectric constant is 3.22 and the dissipation factor is 0.002. Thermal coefficient of expansion for the cladply material having an E-polymer core is about 225 ppm/°C, dielectric strength is about 6000 V/mil, dielectric constant is 3.5 and the dissipation factor is 0.002.

FIG. 5A-5E depict the process steps used to fabricate the electrostatic chuck 200 using the polyimide cladply material described above. For example, FIG 5A depicts a commercially available copper-surfaced cladply polyimide film 500 (e.g., Kapton® HKJ) having a core layer 218 with a thermoplastic adhering layer 502 and 504 on each side of the core layer and a copper layer 506 and 508 deposited upon the surface of each thermoplastic adhering layer 502 and 504.

As depicted in FIG. 5B, surface copper layer 506 is patterned to produce the desired electrode pattern 222 and 220 using standard photoresist and wet etch techniques, while the other surface copper layer 508 is completely removed during the wet etch process. This provides a modified cladply film having the desired electrode pattern on one surface, overlying a thermoplastic adhering polyimide layer 504, overlying a high temperature core center layer 218, which overlays a thermoplastic self-adhering polyimide layer 502. The lower surface of the modified cladply film is the thermoplastic self-adhering polyimide which can be bonded directly to the mounting plate 226.

As shown in FIG. 5C, a second polyimide-comprising layer 216 (a thermoplastic self-adhering polyimide-comprising film with or without a high temperature core layer) is applied over the electrodes 220 and 222. Specifically, the film is Kapton© KJ having a polyimide layer 216 with a self adhering layer 514 of KJ. Alternatively, the polyimide layer may be UPILEX® and a separate layer of KJ film is positioned atop the electrodes to facilitate adhering the UPILEX® to the electrodes. Additionally, a foil 516 (e.g., duo foil) is temporarily placed over the bottom adhesive layer 502. The structure depicted in FIG. 5C is bonded in an autoclave at 350° C and 300 psi to produce the structure shown in FIG. 5D.

At this point, if backside gas distribution grooves (not shown) are desired, the upper surface of the structure 520 can be etched using conventional polyimide etching techniques. Additionally, two holes (one of which is shown in FIG. 5D as hole 522) are etched through layers 216 and 514 to provide a contact point to supply electrical power to the electrodes. The necessity of these holes will become apparent from the following discussion.

FIG. 5D further depicts the layered structure after an access hole 510 (i.e. the hole forms a portion of backside cooling gas conduit 244) and a punched region 512 have been punched through the structure. The punched region 512 forms the lolly pop shaped "tab" that extends from the underside of the structure. A die is used to punch these holes. Since a plurality of the electrostatic chuck structures are simultaneously fabricated upon a large sheet of cladply film, the die cuts the circular shape of each chuck from the film at the same time that the tabs 512 and hole 510 are punched. This tab forms the extension 232 that carries power to the electrode 222. The structure proximate electrode 220 is also punched to form an extension (not shown).

After bonding and punching, the duo foil 516 is removed from (peeled off) the lower adhesive layer 502. This layer is adhered to the mounting plate 226. The punched region 512 extends through hole 230 to form extension 232. The extension is folded over to expose the copper conductor via hole 522 and uses the polyimide layers 216 and 218 as an insulative barrier between the conductive extension 232 and the conductive mounting plate 226. Alternatively, the extensions could be formed as "ears" extending from the edges of the chuck and folded over the edge of the mounting plate to expose the copper at the underside of the mounting plate. The entire assembly depicted in FIG. 5E is again bonded in an autoclave at 350°C and 300 psi to adhere layer 502 to the mounting plate 226 to form the electrostatic chuck 200.

The electrostatic chuck, may also be fabricated using liquid polyimide materials which are deposited and cured in a layered manner as disclosed in common assigned U.S. Patent Application Serial Number 08/381,258, filed January 31, 1995.

Although a polyimide-based electrostatic chuck is described as the preferred embodiment of the invention for fabrication cost and relative ease of fabrication, other electrostatic chuck assemblies would also function to improve the heat conduction from a wafer to the cooling pedestal 206. For example, the electrostatic chuck can be a conventional ceramic chuck having a layer of ceramic material with embedded electrodes affixed to the mounting plate. Such a ceramic chuck is described in U.S. patent 5,117,121 issued May 26, 1992 to Watanabe et al. In addition, a dielectric chuck such as is disclosed in U.S. patent 4,384,918 issued May 24, 1983 to Naomichi. A monopolar chuck that could be used in lieu of the bipolar chuck disclosed above is disclosed in U.S. patent application serial No. filed (Attorney Docket No. 1452), and commonly assigned U.S. patent 5,459,632 issued October 17, 1995 to Birang et al., both of which are hereby incorporated by reference. These electrostatic chucks may be bipolar or monopolar as well as driven by either AC or DC chucking voltages. The important feature of the invention is the use of an electrostatic chuck, of any form, to clamp a wafer to a cooling pedestal within a cooldown chamber.

Returning to FIG. 2, the chuck 200 is releasably affixed by a plurality of bolts 236 (or screws) to the pedestal 206. To promote heat conduction from the mounting plate 226 to the pedestal 206, an aluminum sheet 242 is placed between the bottom surface of the mounting plate and the top surface of the pedestal. The plate is then bolted by peripheral bolts 236 to the pedestal such that the aluminum sheet 242 is sandwiched between the plate and the pedestal.

To facilitate degassing of the polyimide layer(s), a degassing assembly is provided to remove water vapor from the cooldown chamber. Degassing can be provided by merely exposing the chamber volume 204 to vacuum for a period of time before use. However, to more rapidly degas the chamber, a heating element is preferred. The heating element can be a lamp assembly (not shown) mounted external to the chamber. To allow heat from the lamp assembly to enter the chamber, a quartz window is located in the sidewall or top 202 of the enclosure. However, the preferred degassing technique directly heats the electrostatic chuck. As such, a heating element 201 is located between the electrostatic chuck mounting plate 226 and the pedestal 206. The heating element 201 is a dielectric layer (e.g., a ceramic material) containing an imbedded heating coil 203. The coil 203 is connected to a power supply 208 and produces heat when energized. Periodically activating the heating element 201 conductively heats the electrostatic chuck 200 to "bake out" any water vapor retained by the polyimide layer(s).

The pedestal which supports the electrostatic chuck 200 (and, optionally, the heating element 201) is a substantially hollow cylindrical block of aluminum or stainless steel. Within the hollow interior of the pedestal, there is a coil 238 of tubing for carrying a coolant such as chilled water. To promote heat conduction from the pedestal to the coil, the coil physically contacts the interior surface (top interior surface 240) of the pedestal 206. The tubing 238 is connected to a heat exchanger 212 that is located external to the cooldown chamber 102. The heat exchanger 212 pumps coolant through the coils to remove heat that is conducted into the pedestal and then, in turn, to the tubing and coolant. As such, the heat exchanger effectively removes heat from the pedestal.

Optionally, to provide improved heat transfer from the workpiece (not shown) which is held to the surface of second dielectric layer 224, a heat transfer gas is applied to the surface of dielectric layer 224 through a conduit 244. Conduit 244 leads to gas distribution channels (not shown) in the surface of dielectric layer 224. The channels can take various geometrical forms. Heat transfer gas is fed from a gas source 210 through conduit 244 to the gas distribution channels during processing of the substrate/workpiece. Since there are numerous processes known in the art for etching polyimides, the gas distribution channels can easily be etched into the polymeric dielectric layer 224.

In addition, the optional heating element 201 can be used in combination with the thermally conductive pedestal 206 and its heat exchanger 212 to achieve a particular temperature for a wafer. Specifically, in such an alternative embodiment, a temerature control circuit 250 is coupled to the heating element power supply 208 as well as to the heat exhanger 212. The circuit 250 selectively activates the heating element 201 and the heat exchanger 212 to heat/cool the wafer to a particular temperature. The wafer temperature can be monitored using a pyrometer, electro-optic sensor, thermocouple, and the like (not specifically shown). One or more of these sensors could be incorporated into the control circuit 250 to form a closed-loop, temperature control subsystem.

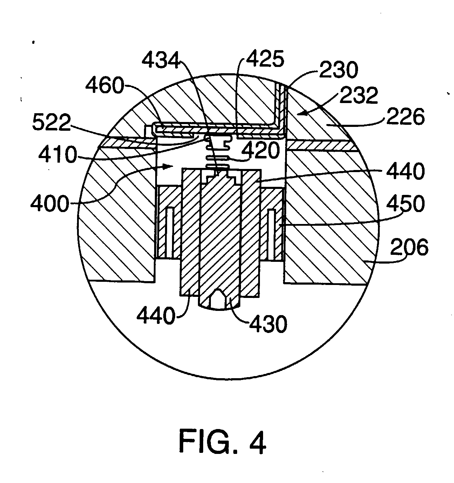

As previously mentioned, the electrostatic chuck of the present invention requires an electrical connector capable of functioning at high temperatures, typically greater than about 175°C, and can range as high as about 500°C. One illustrative electrical connector is depicted in Fig. 4. Electrical connector 400 is designed to make contact with electrical connection extensions 232 of the type shown in Fig. 2 and in Fig. 4. These electrical connection extensions extend into the mounting plate 226 from the electrostatic chuck electrodes and are insulated from the plate by an insulating material 460. As discussed above with respect to FIG. 5, the insulating material 460 on both sides of the electrode extension is formed by the dielectric layers used to fabricate the electrostatic chuck. To assure intimate contact with such extensions, a spring loaded electrical connector 400 is used. The spring loaded connector is preferably welded into pedestal base 206 to provide a vacuum seal between the electrical connector 400 and the pedestal 206.

A conductive contact button 410 extends from the top of electrical connector 400 to make contact with the conductive extension 232 via hole 522 through the insulating material 460. Intimate contact is achieved between the conductive extension and contact button 410 using a spring 420 to urge contact button 410 toward a conductive surface 425 of conductive extension 232. Spring 420 is connected at location 432 to an extension 434 of the upper portion of solid conductive center contact 430. Surrounding conductive center contact 430 is a dielectric insulator 440 which isolates center contact 430 from the surrounding pedestal base 206. Dielectric insulator 440 is circumscribed by a conductive clip 450 which is welded into the pedestal. Conductive clip 450 has a thermal coefficient of expansion which is compatible with the thermal coefficient of expansion of the dielectric insulator 440 and the conductive material of the pedestal base 206. A wire is soldered to the lower end of the center contact 430 to connect the contact to the power supply.

The materials of construction of the high temperature electrical contact 400 are as follows: conductive contact button 410 is stainless steel; spring 420 is stainless steel; solid conductive center contact 430 is fabricated from niabrium; dielectric insulator 440 is constructed from 95-97% alumina; and conductive clip 450 is fabricated from Kovar. Other materials of construction having substantially equivalent relative thermal expansion coefficients, electrical, mechanical and chemical properties can be substituted. Insulator 440 is chosen to have a coefficient of thermal expansion which varies from the coefficient of expansion of solid conductive center contact 430 by less than about 10%. Further, the insulator 440 coefficient of thermal expansion should range between the coefficient of thermal expansion of solid conductive center contact 430 and the coefficient of thermal expansion of conductive clip 450, to reduce the stress created within and between these materials over the operational temperature of the electrostatic chuck.

Now, the operation of the cooldown chamber is described with respect to the polyimide-based, bipolar electrostatic chuck described in detail above.

After the second transport mechanism has positioned the wafer upon the top surface of the second polyimide layer 224, the high voltage power supply 208 applies a voltage of approximately 200 to 2,000 volts DC to the electrode pair. Consequently, charges are accumulated upon the underside of the wafer, and these charges are attracted via coulomb force to the potential that is applied to the electrodes. As such, since the charges that accumulate on the underside of the wafer cannot pass through the polyimide insulating layer 224, the wafer, as a whole, is attracted to the electrodes. As such, the wafer is electrostatically retained upon the surface of the chuck. The wafer maintains this position until the high voltage DC power is removed from the electrodes, at which time the transport mechanism may return to the cooldown chamber and use the wafer transport blade to lift the wafer from the top of the second polyimide layer 224.

While the wafer is chucked, it is in close proximity to the top polyimide layer such that heat is rapidly transferred through both polyimide layers, the electrodes and the mounting plate into the thermally conductive pedestal. Consequently, the heat is carried away to the heat exchanger, and the wafer is rapidly cooled. In this manner, an atmospheric change within the cooldown chamber is not necessary to rapidly cool the wafer. Consequently, the cryo pump does not require regeneration as often as needed in the prior art. However, the wafer may be cooled even faster if 4 Torr of argon gas is pumped into the interstitial spaces between the wafer and the chuck, i.e., using a backside cooling technique. With such backside cooling, heat transfer is substantially improved, thus cooling the wafer very rapidly.

In use, a cooldown chamber designed in accordance with the present invention and using backside cooling, cools an eight-inch wafer from a temperature of 450°C to 100°C in approximately 10-15 seconds. This is an improvement of three- to four-fold over the cooling time required by the prior art. Additionally, a cooldown chamber of the present invention does not require an atmosphere to be present to enhance the cooling time. As such, there is no buffering of atmospheric gas necessary prior to access by the robotic transport mechanism into the cooldown chamber nor is repetitive cryo pump regeneration necessary.

Although various embodiments which incorporate the teachings of the present invention have been shown and described in detail herein, those skilled in the art can readily devise many other varied embodiments that still incorporate these teachings.

## Claims

1. Apparatus for cooling a workpiece in absence of a process chamber atmosphere comprising:
a thermally conductive pedestal having a mounting surface; and
an electrostatic chuck, releasably affixed to said mounting surface of said thermally conductive pedestal, for electrostatically retaining said workpiece in thermal contact with a support surface of said electrostatic chuck.

2. The apparatus of claim 1 wherein said electrostatic chuck comprises:
a first polymeric dielectric layer;
a pair of electrodes affixed to said first polymeric dielectric layer; and
a second polymeric dielectric layer affixed to said pair of electrodes and forming the support surface.

3. The apparatus of claim 1 wherein said thermally conductive pedestal comprises:
a portion defining a volume;
a heat exchanger element, contained in the inner volume, for transferring heat from within the volume to a location outside the volume.

4. The apparatus of claim 1 further comprising a chamber, capable of maintaining a vacuum, having the thermally conductive pedestal and electrostatic chuck contained therein.

5. The apparatus of claim 2 wherein the first polymeric dielectric layer is affixed to a thermally conductive mounting plate.

6. The apparatus of claim 1 wherein the electrostatic chuck is affixed to a mounting plate and the mounting plate is releasably affixed to the mounting surface of the thermally conductive pedestal.

7. The apparatus of claim 6 wherein said mounting plate comprises:
a substantially circular, raised center portion for supporting said electrostatic chuck;
a mounting flange, extending radially from said center portion; and
means, releasably attached to said mounting flange, for releasably attaching said mounting flange to said mounting surface of said thermally conductive pedestal.

8. The apparatus of claim 7 wherein said mounting plate further comprises:
an aperture formed through said substantially circular, raised center portion; and
an electrode extension attached at a first end to an electrode of said electrostatic chuck and having a second end defining a contact surface.

9. The apparatus of claim 8 wherein said mounting surface of said thermally conductive pedestal further comprises:
means for releasably forming an electrical contact with said contact surface of said electrode extension.

10. The apparatus of claim 9 wherein said means comprises:
a central conductive contact supported in an aperture in said mounting surface by an insulator ring; and
a spring, supported at a first end by a first end of said central conductive contact, for biasing a conductive contact button, located at said second end of said spring into contact with said contact surface of said electrode extension.

11. The apparatus of claim 1 further comprising:
a conduit connecting the support surface of said electrostatic chuck to a coolant gas supply.

12. The apparatus of claim 1 further comprising a degassing means for degassing said electrostatic chuck.

13. The apparatus of claim 12 wherein said degassing means is a heating element located between said thermally conductive pedestal and said electrostatic chuck.

14. The apparatus of claim 3 further comprising:
a heating element for heating said electrostatic chuck; and
a control circuit, coupled to said heating element and said heat exchanger element, for controlling the temperature of said workpiece.

15. A cooldown chamber for a semiconductor processing system comprising:
a vacuum chamber defining a volume;
a thermally conductive pedestal, located within said volume, having a mounting surface; and
an electrostatic chuck, affixed to said mounting surface of said thermally conductive pedestal, for electrostatically retaining said workpiece in thermal contact with a support surface of said electrostatic chuck.

16. The cooldown chamber of claim 15 wherein said thermally conductive pedestal comprises:
a portion defining a pedestal volume;
a heat exchanger element, contained in the pedestal volume, for transferring heat from within the pedestal volume to a location outside the chamber volume.

17. The cooldown chamber of claim 15 wherein the electrostatic chuck is affixed to a mounting plate and the mounting plate is releasably affixed to the mounting surface of the thermally conductive pedestal.

18. The cooldown chamber of claim 15 further comprising a degassing means for degassing said electrostatic chuck.

19. The cooldown chamber of claim 18 further comprising a heating element located between said mounting plate and said thermally conductive pedestal.

20. The apparatus of claim 15 further comprising:
a conduit connecting the support surface of said electrostatic chuck to a coolant gas supply.

21. The apparatus of claim 16 further comprising:
a heating element for heating said electrostatic chuck; and
a control circuit, coupled to said heating element and said heat exchanger element, for controlling the temperature of said workpiece.

22. A method of cooling a workpiece comprising the steps of:
positioning a workpiece upon a support surface of an electrostatic chuck within a cooldown chamber, where said electrostatic chuck is supported by a thermally conductive pedestal; and
applying power to the electrostatic chuck to electrostatically retain the workpiece upon the support surface, whereby heat is conducted from said workpiece through said electrostatic chuck and into said thermally conductive pedestal.

23. The method of claim 22 further comprising the step of applying a coolant gas between the workpiece and the support surface to enhance thermal conduction from the workpiece to the support surface.

24. The method of claim 23 further comprising the step of extracting heat from said thermally conductive pedestal using a heat exchanger.
